Europäisches Patentamt

European Patent Office

Office européen des brevets

(11) Veröffentlichungsnummer: **0 443 069 A1**

# EUROPÄISCHE PATENTANMELDUNG

(21) Anmeldenummer: 90103479.3

(22) Anmeldetag: 22.02.90

(51) Int. Cl.5: **G01R 33/025**

(43) Veröffentlichungstag der Anmeldung:
28.08.91 Patentblatt 91/35

(84) Benannte Vertragsstaaten:
DE FR GB IT NL

(71) Anmelder: **Siemens Aktiengesellschaft**
**Wittelsbacherplatz 2**
**W-8000 München 2(DE)**

(72) Erfinder: **Abraham-Fuchs, Klaus, Dipl.-Phys.**
**Graslitzer Strasse 17**
**W-8520 Erlangen(DE)**

(54) **Verfahren zur Messung des Feldmusters elektrischer oder magnetischer Felder mit Hilfe einer Sensoranordnung.**

(57) Das Verfahren zur optimalen Darstellung der räumlichen Lage einer zu ermittelnden Stromquelle (10) dient der Kompensation einer Hintergrund-Aktivität (B) aus deren zu einem Zeitpunkt $t_0$ vor Beginn der Aktivität der zu ermittelnden Stromquelle (10) zwischen den Zeitpunkten $t_1$ und $t_2$, gemessenen Werten der resultierende Signalvektor ($\overline{S}_N$ (B) ($t_0$)) der Hintergrund-Aktivität (B) gebildet wird, der von jedem resultierenden Vektor ($\overline{S}_N$ (M) ($t_x$)) der zu den Zeitpunkten $t_x$ zwischen den Zeitpunkten $t_2$ und $t_3$ gemessenen Werte vektoriell subtrahiert wird, so daß ein im wesentlichen nur vom Strom der zu ermittelnden Stromquelle (10) verursachter Signalvektor ($\overline{S}_N$ - (Q)) gebildet wird, wobei ein die Länge des Vektors des Hintergrundfeldes (B) verändernder Wichtungsfaktor (W) zusammen mit den gesuchten Quellenparametern ($Q_i$) durch Fehlerminimierung iterativ derart bestimmt werden, daß die Parameter der gesuchten Stromquelle (10) optimal darstellbar sind.

FIG 2

Die Erfindung betrifft ein Verfahren zur Messung des Feldmusters elektrischer oder magnetischer Felder mit Hilfe einer Sensoranordnung sowie mit einer Datenverarbeitungsanlage zur iterativen Ermittlung der räumlichen Lage einer das Feld verursachenden Stromquelle nach dem Oberbegriff des Patentanspruches 1.

Die Messung von gegenüber dem Erdmagnetfeld um mehrere Zehnerpotenzen schwächerer Magnetfeldern hat besonders in Verbindung mit biomagnetischen Aktivitäten Bedeutung erlangt. Dabei geht es darum, die von Nervenströmen im Inneren eines lebenden Organismus ausgehenden Außenfelder mit Hilfe entsprechender Sensoren an verschiedenen Orten zu messen und aus dem so gemessenen Feldmuster mit Hilfe einer entsprechenden Datenauswertung den Ort eines äquivalenten Dipols zu ermitteln. Die dazu erforderlichen Meßeinrichtungen müssen außerordentlich empfindlich sein und man bedient sich dazu spezieller Gradiometer, die zusammen mit einem supraleitenden Quanteninterferrometer (SQUID) in einem Dewargefäß unter supraleitenden Bedingungen untergebracht sind. Um auf diese Weise eine aussagekräftige Messung zu ermöglichen, müssen vor allem auch die äußeren Störfelder bestmöglich abgeschirmt werden. Dazu werden Patient und Meßeinrichtung in einer begehbaren magnetischen Abschirmkammer untergebracht. Um die Feldverteilung möglichst rasch ermitteln zu können, sind Vielkanalsysteme entwickelt worden, wie sie beispielsweise in der Druckschrift "Electromedica" 57, 1989, Seiten 2 bis 7, beschrieben sind.

Nun verfälschen aber nicht nur von außen einwirkende Störfelder das Meßergebnis. Es ist vielmehr häufig der Fall, daß die gesuchte, das äußere Magnetfeld verursachende bioelektrische Stromquelle von den Aktivitäten einer benachbarten Quelle additiv überlagert wird. Diese "Hintergrund-Aktivität" kann zu einem Fehler bei der Lokalisierung der gesuchten Stromquelle führen. Dieser Fall tritt insbesondere bei den biomagnetischen Herzaktivitäten (Magnetokardiogramm) auf. Wenn ein solches überlagertes Feld ausreichend bekannt ist, kann es vom gemessenen Feld subtrahiert werden, um das Feld der gesuchten Stromquelle zu erhalten. Eine solche konstante Aktivität ist aber insbesondere bei den Reizströmen des Herzens nicht gegeben. So erzeugt eine elektro-physiologische Aktivität in diesem Bereich während eines bekannten Zeitabschnittes ein elektrisches oder magnetisches Feld, dessen räumliches Feldmuster in diesem Zeitraum angenähert konstant bleibt, sich aber um einen Amplitudenfaktor in Abhängigkeit von der Zeit ändert, z.B. langsam zu- und abnimmt. Der Verlauf dieser zeitlichen Änderung des Amplitudenfaktors ist nicht bekannt. Eine solche Änderung tritt z.B. auf, wenn eine elektro-physiologische Aktivität tritt z.B. auf, wenn eine elektro-physiologische Aktivität

vität nach Ort und Richtung stabil bleibt, die Stromdichte des Ionenflusses aber langsam abnimmt. Beispielsweise ist dies bei der Repolarisierung der Herz-Vorhöfe im P/Q-Intervall des Herzzyklus der Fall. Überlagert sich diese Aktivität nach dem Beginn eines bestimmten Zeitabschnittes (Zeitfenster) mit konstantem Feldmuster einer weiteren Aktivität, die lokalisiert werden soll, so kann dieses Hintergrund-Feldmuster zu einem bestimmten Zeitpunkt vor dem Einsetzen der Aktivität, die lokalisiert werden soll, gemessen werden und, bliebe diese Aktivität konstant, vom zu messenden Feldmuster subtrahiert werden. Bleibt die Hintergrund-Aktivität aber, wie dies praktisch der Fall ist, während der Dauer des Meßzyklus zur Ermittlung der zu bestimmenden Aktivität nicht konstant, so funktioniert diese einfache Subtraktionsmethode nicht.

Der Erfindung liegt die Aufgabe zugrunde, eine HintergrundAktivität physiologischen oder technischen Ursprungs, deren Feldmuster zu einem bestimmten Zeitpunkt vor dem Einsetzen der zu messenden Aktivität bestimmbar ist, unter Berücksichtigung ihres Amplitudenverlaufes während der Dauer der Meßperiode so zu definieren, daß sie zu jedem Meßzeitpunkt in der richtigen Größe von der Gesamtgröße abgezogen werden kann.

Diese Aufgabe wird durch das im Patentanspruch 1 angegebene Verfahren gelöst. Durch die Zuordnung eines Wichtungsfaktors zum Vektor des Hintergrundfeldes, der dessen Amplitudenschwankung in Abhängigkeit von der Zeit zu den einzelnen Meßpunkten ermittelt, ist erreicht, daß die Felddifferenz zwischen dem gemessenen Feld und dem von der zu bestimmenden Stromquelle ausgehenden Feld und damit das Muster dieses Feldes selbst bestmöglich bestimmt werden kann.

Am Beispiel einer Anordnung für magnetokardiographische Messungen (MKG) und dieser zugeordneten Diagrammen sei das Verfahren im folgenden näher erläutert. Es zeigen:

Fig. 1 eine Meßanordnung für magnetokardiographische Messungen mit einem Vielkanalgradiometer mit SQUID-Elementen,

Fig. 2 einen Ausschnitt aus einer von einem einzelnen SQUID-Gradiometer aufgenommenen Zeitkurve, und

Fig. 3 ein Vektordiagramm mit zwei Meßwertteilräumen, das den Zusammenhang von Meßwertsignal, Quellsignal und Hintergrundsignal geometrisch veranschaulicht.

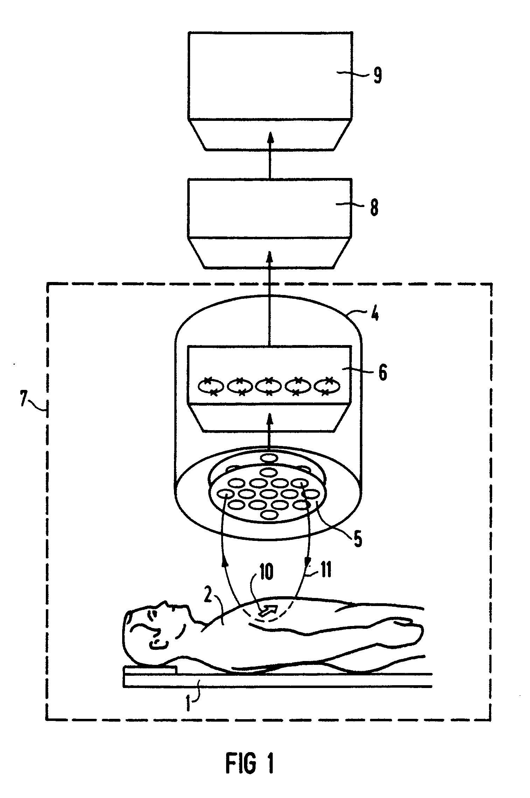

Die in Fig. 1 dargestellte Anordnung besteht aus einer Patientenlagerstatt 1 zur Lagerung des Patienten 2, einem über dem Patienten angeordneten DEWAR-Gefäß 4, das eine Vielkanal-Gradiometeranordnung und den Gradiometern zugeordneten DC-SQUIDS enthält. Patientenlagerstatt 1 und DEWAR-Gefäß 4 sind in einer Abschirmkammer 7 gegen das Einwirken äußerer magnetischer Felder untergebracht. Eine Elektronikeinheit 8 dient der Steuerung und Stromversorgung der SQUID-Gradiometer 5. Die Signalauswertung der von den SQUID-Gradiometern ermittelten Meßwerte, die den zeitlichen Verlauf des von einem äquivalenten Dipol 10 ausgehenden, den Körper des Patienten umgebenden Magnetfeldes 11 an den verschiedenen Meßorten, geschieht in einem Rechner 9, nach einem bestimmten Iterationsalgorithmus.

Nun wird das gemessene Magnetfeldmuster häufig nicht nur von einer einzigen, räumlich lokalisierbaren Stromquelle erzeugt. Vielmehr kommt es vor, daß sich einer Aktivität, deren Stromquelle lokalisiert werden soll, eine weitere Aktivität überlagert, die beispielsweise aus einer Voraktivität stammen kann, die sich über einen größeren Gewebekomplex diffus und mit wachsender oder abklingender Amplitude verbreitet und sich dem Feld der zu lokalisierenden Stromquelle additiv überlagert. Ein solches Hintergrundfeld ist geeignet, das interessierende Feldmuster derart zu beeinflussen, daß die Auswertung zu einer falschen Lokalisierung der Stromquelle führt.

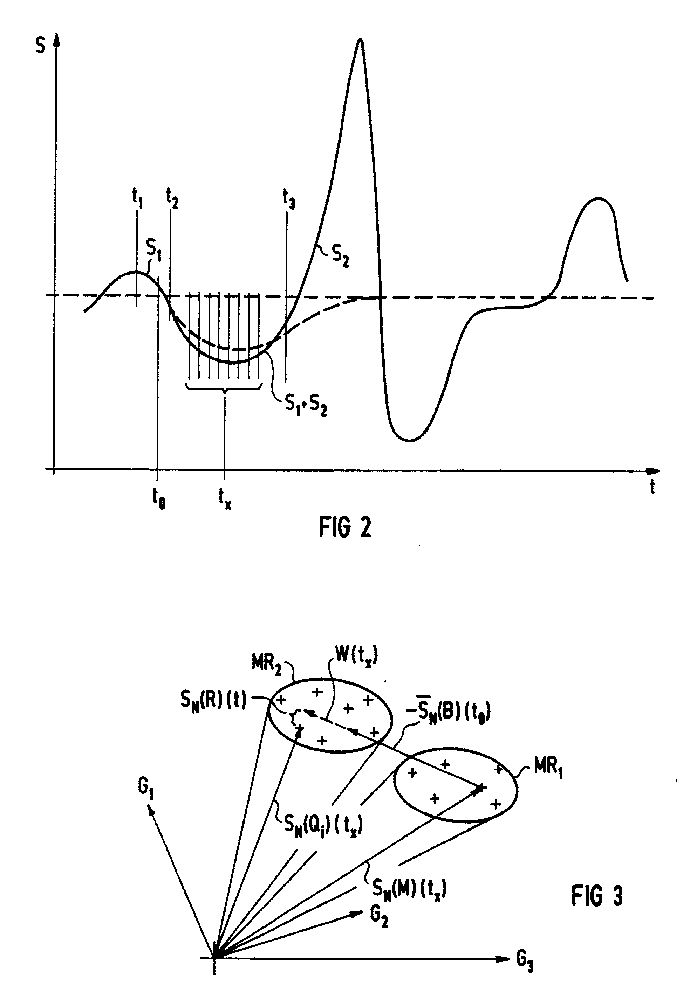

In Fig. 2 ist der am Ort eines der Gradiometer gemessene zeitliche Verlauf eines äußeren, von einer Herzaktivität herrührenden Magnetfeldes (MKG) dargestellt. Dabei soll lediglich ein Ausschnitt (Zeitfenster) der Kurve betrachtet werden. Das Zeitfenster beginnt mit dem Zeitpunkt $t_1$ und endet beim Zeitpunkt $t_3$. Die zum Zeitpunkt $t_1$ abklingende Aktivität $S_1$ stammt aus der Repolarisierung der Herz-Vorhöfe im P/Q-Intervall des Herzzyklus. Dabei handelt es sich um eine Aktivität, deren magnetisches Feldmuster in diesem Zeitraum annähernd konstant bleibt, sich aber um einen Amplitudenfaktor ändert, d.h. langsam zu- und abnimmt. Diese zeitliche Änderung des Amplitudenfaktors ist nicht bekannt. Sie tritt z.B. auf, wenn eine elektro-physiologische Aktivität in Ort und Richtung stabil bleibt, die Stromdichte des Ionenflusses aber langsam abnimmt. Die Amplitude dieser Aktivität $S_1$ klingt entsprechend ab. Zum Zeitpunkt $t_2$ setzt nun die Herzkammeraktivität $S_2$ ein, die lokalisiert werden soll. Beide Aktivitäten überlagern sich während der gesamten Fensterdauer. Dabei kann das von den Sensoren gemessene Signal zu einem Zeitpunkt t in vektorieller Darstellung folgendermaßen beschrieben werden:

$$\|\overline{S}_N\,(M)\,(t) = \overline{S}_N\,(Q)\,(t) + \overline{S}_N\,(B)\,(t) + \overline{S}_N\,(R)\,(t)\|$$

Um einen darauf zurückzuführenden Lokalisierungsfehler zu vermeiden, muß die Aktivität $S_1$ von der Aktivität $S_2$ subtrahiert werden. Dazu wird zunächst die Aktivität $S_1$ zu einem Zeitpunkt $t_0$, zu dem diese noch allein auftritt, bestimmt. Da die Amplitude dieser Aktivität über die Zeit nicht konstant ist, führt eine Subtraktion nach der Gleichung

$$\|\overline{S}_N\,(M)\,(D_x)\,-[\,\overline{S}_N\,(Q_i)\,(t_x) + \overline{S}_N\,(B)\,(t_0) + \overline{S}_N\,(R)\,(t)]\| = O$$

nicht zum Ziel. Vielmehr bedarf es dazu der Einführung eines Wichtungsfaktors W, mit dem der Vektor des Hintergrundsignals $\overline{S}_N\,(B)$ zum jeweiligen Meßzeitpunkt tx multipliziert werden muß. Dann lautet die Formel unter Vernachlässigung des Vektors $\overline{S}_N\,(R)\,(t)$:

$$\|\overline{S}_N\,(M)\,(t_x)\,-[\,\overline{S}_N\,(Q_i)\,(t_x) + W\,(t_x) \times \overline{S}_N\,(B)\,(t_n)]\|$$

$$= \text{Minimum.}$$

In diesen Formeln bedeuten:

$\overline{S}_N\,(M)\,(t) =$ Vektor des Meßsignals $S_1$ + $S_2$ in N Sensoren zum Zeitpunkt t;

$\overline{S}_N\,(Q)\,(t) =$ Vektor des Signals $S_2$ der gesuchten Stromquelle am Gesamtsignal in N Sensoren zum Zeitpunkt t;

$\overline{S}_N\,(B)\,(t) =$ Vektor der Hintergrund-Aktivität $S_1$ in N Sensoren zum Zeitpunkt t;

$\overline{S}_N\,(R)\,(t) =$ Vektor des Rauschanteiles in N Sensoren zum Zeitpunkt t;

$W\,(t) =$ Wichtungsfaktor für die Länge des Vektors $\overline{S}_N\,(B)\,(t)$;

$Q_i\,(tx) =$ Parameter, die die Stromquelle und damit deren Signal zum Zeitpunkt $t_x$ eindeutig bestimmen.

Diese Gleichung wird deshalb nicht zu Null, weil sich das Hintergrundfeld aus der eigentlichen Hintergrund-Aktivität $\overline{S}_N\,(B)$ und dem pauschalen Rauschanteil $\overline{S}_N\,(R)$ additiv zusammensetzt.

Dieser Vorgang ist in Fig. 3 veranschaulicht: Der Meßwertvektor $\overline{S}_N\,(M)$ beschreibt einen Punkt im Meßwertteilraum $MR_1$. Der gesamte Meßwertteilraum wird durch die Signale in jedem der drei dargestellten Sensoren $G_1$, $G_2$ und $G_3$ aufgespannt und hat die Dimension N, wobei N die Anzahl der Sensoren bezeichnet. In Wirklichkeit ist die Anzahl der Sensoren sehr viel höher, beispielsweise 37. Das Signal $\overline{S}_N\,(Q)$ dieser vorgegebenen Modell-Stromquelle (z.B. Stromdipol) kann unter Variation aller Quellparameter $Q_i$ nur diskrete Punkte im Meßwertteilraum beschreiben, die beispielshaft durch Kreuze markiert sind. Die Suchstrategie sucht nun denjenigen aller möglicher Signalvektoren der Stromquelle $\overline{S}_N\,(Q)$ der dem aktuellen Meßwert $\overline{S}_N\,(M)$ am nächsten liegt. Würde man die Lösung für die Stromquelle ohne eine auf das Hintergrundfeld $\overline{S}_N\,(B)$ bezogener Korrektur suchen, erhielte man zwar eine Lösung im Meßwertteilraum $MR_1$. Diese würde jedoch zu einer fehlerhaften Quellenortung führen. Durch die Subtraktion des Hintergrundfeldes $\overline{S}_N$ (B) wird die Suchstrategie veranlaßt, eine Lösung in der Nähe des neuen, korrigierten Meßsignales $\overline{S}_N$ (M) - $\overline{S}_N$ (B), also im Meßwertteilraum $MR_2$ zu suchen. Der Wichtungsfaktor W für die Länge des Korrekturvektors $\overline{S}_N$ (B) wird dabei iterativ so optimiert, daß der resultierende Vektor W $\overline{S}_N$ (B) der richtigen Lösung so nahe wie möglich kommt.

## Patentansprüche

Verfahren zur Messung des Feldmusters elektrischer oder magnetischer Felder mit Hilfe einer Sensoranordnung sowie mit einer Datenverarbeitungsanlage zur iterativen Ermittlung der räumlichen Lage einer das Feld verursachenden Stromquelle aufgrund des zeitlichen Amplitudenverlaufes und der räumlichen Verteilung des von der zu ermittelnden Stromquelle gebildeten sowie dem von einer Hintergrund-Aktivität zusammengesetzten Feldes, wobei die zu bestimmten Zeitpunkten $t_x$ innerhalb eines vorgegebenen Zeitfensters zwischen zwei Zeitpunkten $t_1$ und $t_3$ erhaltenenMeßwerte einen vektoriellen Meßwertraum bilden, **dadurch gekennzeichnet**, daß zur Kompensation der Hintergrund-Aktivität (B) aus deren zu einem Zeitpunkt $t_0$ vor Beginn der Aktivität der zu ermittelnden Stromquelle (10) zwischen den Zeitpunkten $t_1$ und $t_2$, gemessenen Werten der resultierende Signalvektor ($\overline{S}_N$ (B) ($t_0$)) der Hintergrund-Aktivität (B) gebildet wird, der von jedem resultierenden Vektor ($\overline{S}_N$ (M) ($t_x$)), der zu den Zeitpunkten $t_x$ zwischen den Zeitpunkten $t_2$ und $t_3$ gemessenen Werte, vektoriell gewichtet subtrahiert wird, so daß ein im wesentlichen nur dem vom Strom der zu ermittelnden Stromquelle (10) verursachter Signalvektor ($\overline{S}_N$ (Q)) gebildet wird, wobei ein die Länge des Vektors ($\overline{S}_N$ (B) ($t_0$)) des Hintergrundfeldes (B) verändernder Wichtungsfaktor (W) zusammen mit den gesuchten Quellparametern ($Q_i$) durch Fehlerminimierung iterativ derart bestimmt wird, daß die Parameter der gesuchten Stromquelle (10) optimal darstellbar sind.

**FIG 1**

FIG 2

FIG 3

**Europäisches Patentamt**

**EUROPÄISCHER RECHERCHENBERICHT**

Nummer der Anmeldung

**EP 90 10 3479**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PATENT ABSTRACTS OF JAPAN, Band 9, Nr. 86 (P-349)[1809], 16. April 1985; & JP-A-59 216 077 (BOEICHO GIJUTSU KENKYU HONBU) 06-12-1984 * Ganzes Dokument * | 1 | G 01 R 33/025 |
| | − − − | | |
| A | US-A-4 739 262 (J.M. FLEETWOOD) * Zusammenfassung; Spalte 7, Zeilen 5-18 * | 1 | |
| | − − − | | |
| A | FR-A-2 619 454 (AUTOMATISME ET TECHNIQUES AVANCEES) * Seite 3, Zeilen 8-20 * | | |
| | − − − − − | | |

| | RECHERCHIERTE SACHGEBIETE (Int. Cl.5) |
|---|---|
| | G 01 R |

Der vorliegende Recherchenbericht wurde für alle Patentansprüche erstellt

| Recherchenort | Abschlußdatum der Recherche | Prüfer |
|---|---|---|
| Den Haag | 31 Oktober 90 | HAASBROEK J.N. |